# EUROPÄISCHE PATENTSCHRIFT

(11) **EP 1 047 805 B1**
(45) Veröffentlichungstag und Bekanntmachung des Hinweises auf die Patenterteilung: **02.04.2003**
(21) Anmeldenummer: 99900703.2
(22) Anmeldetag: 11.01.1999
(51) Int. Cl.: C23C 14/08, C23C 14/00, C23C 14/02

(54) **VERFAHREN ZUM BESCHICHTEN VON FOLIE AUS NICKEL ODER NICKELLEGIERUNG**
METHOD FOR COATING FOIL COMPRISED OF NICKEL OR NICKEL ALLOY
PROCEDE D'APPLICATION DE REVETEMENT SUR UN FILM DE NICKEL OU D'ALLIAGE DE NICKEL

(30) Priorität: 12.01.1998 DE 19800758; 06.02.1998 DE 19804751
(43) Veröffentlichungstag der Anmeldung: 02.11.2000
(73) Patentinhaber: STORK VECO B.V., 6961 LB Eerbeek (NL); Koninklijke Philips Electronics N.V., 5621 BA Eindhoven (NL)
(72) Erfinder: GULIKERS, Josephus, Gertudis, Wilhelmus, Pierre, NL-7323 RM Apeldoorn (NL); GOEDICKE, Klaus, D-01307 Dresden (DE); LIEBIG, Jörn-Steffen, D-01474 Malschendorf (DE); MALOBABIC, Peter, A-9020 Klagenfurt (AT); HOCHREITER, Erwin, A-9020 Klagenfurt (AT)
(74) Vertreter: Volmer, Johannes Cornelis
(86) Internationale Anmeldenummer: NL9900014
(87) Internationale Veröffentlichungsnummer: WO99035301

(56) Entgegenhaltungen:
- DE-A- 4 433 863
- US-A- 5 543 183
- FAN J C C: "Selective-black absorbers using sputtered cermet films" INTERNATIONAL CONFERENCE ON METALLURGICAL COATINGS, SAN FRANCISCO, CA, USA, 3-7 APRIL 1978, Bd. 54, Nr. 2, Seiten 139-148, XP002099734 ISSN 0040-6090, Thin Solid Films, 16 Oct. 1978, Switzerland

## Beschreibung

Die Erfindung betrifft ein Verfahren zum Beschichten von Folie aus Nickel oder einer Nickellegierung und eine beschichtete Folie aus Nickel oder einer Nickellegierung. Solche beschichtete Folien sind vorzugsweise lateral strukturiert und finden insbesondere als Scherfolien für Elektro-Rasierapparate Verwendung.

Derartige Scherfolien und andere Produkte auf der Basis von Nickelfolien werden meist durch galvanisches Abscheiden hergestellt Durch verschiedene Verfahrensvarianten gelingt es dabei, sowohi eine laterale Strukturierung mit Durchbrüchen als auch überstehende Teile, die eine Scherkante bilden, zu erzeugen.

Es wird in letzter Zeit angestrebt, diese Folien, die auswechselbar sind, aus verschiedenen Gründen visuell erkennbar und verwechslungsfrei zu kennzeichnen, um sie irrtumsfrei unterscheiden zu können, da ihre Anwendungsgebiete unterschiedlich sind.

Es sind verschiedene Verfahren bekannt, auf metallische Folien - insbesondere auf Rasierund Scherfolien - Schichten aufzubringen, die die Gebrauchsdauer von Scherfolien erhöhen und mit denen ein Farbeffekt erreicht wird.

Insgesamt ist festzustellen, dass die bekannten Verfahren zur Herstellung von Scherfolien keine optimale Lösung darstellen. Die wesentlichen Anforderungen an derartige Scherfolien, wie visuelle verwechslungsfreie Kennzeichnung, differenzierte Verwendung für verschiedene Hauttypen oder Körperpartien, dekorative und ästhetisch ansprechende Gestaltung. Verhinderung von Nickelallergie bei Hautkontakt sowie hohe Gebrauchsdauer, werden mit allen bekannten Verfahren nicht erfüllt.

Zur beseitigung dieser Mängel wurde in der noch nicht oftengelegten Deutschen Patentanmeldung 19800758.2vorgeschlager die vorzugsweise galvanisch hergestellte Folie aus Nickel oder einer Nickellegierung im Vakuum im Bereich von mindestens einer Seite in einem Argonplasma bei einem Druck von 10⁻³ bis 10⁻² mbar eine einstellbare Zeit mit einer einstellbaren Rate und Energie der Ionen des Plasmas zu behandeln. Anschließend wird durch reakuves Magnetron-Zerstäuben mindestens eines Targets aus Chrom oder einer chromhaltigen Legierung mrt mindestens einer Zerstäubungsquelle in einem Argon-Sauerstoff-Gemisch bei einem Druck von 10⁻³ bis 10⁻² mbar eine Chromoxidschicht aufgestäubt. Dabei wird der Arbeitspunkt in vorgegebenen Grenzen konstant gehaiten. Die Folie ist wahrend des Beschichtens in einem definierten Wärmekontakt mit einem Wärmepuffer verbunden. Bis zum Erreichen einer vorgegebenen Interferenzfarbe einer Interferenz erster oder zweiter Ordnung auf der Folie wird die Beschichtung fortgesetzt.

Die nach der Patentanmeldung 198 00 758.2 vorgeschlagene beschichtete Folie aus Nickel oder einer Nickellegierung, die insbesondere als Scherfolie für Elektro-Rasierapparate verwendet wird, ist vorzugsweise nach einem galvanischen Verfahren hergestellt, und im Bereich von mindestens einer Seite ist im Vakuum eine Schicht aus einer Metallverbindung aufgestäubt. Diese Schicht besteht aus einem Oxid des Chroms oder einer chromhaltigen Legierung. Die Dicke dieser Schicht ist durch eine vorgegebene Interferenzfarbe einer Interferenz erster oder zweiter Ordnung bestimmt. Der Schichtdickenbereich liegt zwischen 20 und 300 nm.

Diese vorzugsweise galvanisch hergestellten Folien aus Nickel oder einer Nickellegierung werden nach ihrer Herstellung durch einen Wasch- und Trockenprozess gereinigt Es ist jedoch selbst bei intensiver Prozessdurchführung nicht zu verhindern, dass lokal begrenzt Verschmutzungen - vor allem durch Trockenrückstände - auftreten. So ist es unvermeidbar, dass besonders in der Umgebung der Durchbrüche der Scherfolien eine dünne Verunreinigungsschicht in Form von Schlieren und Trockenrückständen auftritt. Diese Verunreinigungen führen bei dem vorgeschlagenen Verfahren gemäß der Patentanmeldung 198 00 758.2 dazu, dass keine optimale Abrasionsbeständigkeit erreicht wird. Selbst durch eine Intensivierung des Plasmabehandlungsprozesses lassen sich die ungünstigen Auswirkungen von solchen Verunreinigungsschichten auf der Nickeloberfläche nicht kompensieren.

Bei den beschichteten Folien aus Nickel oder einer Nickeliegierung, die derzeit vorzugsweise nach dem vorgeschlagenen Verfahren hergestellt sind, und die mindestens auf einer Seite mit einer im Vakuum aufgestäubten Schicht aus einer Metallverbindung versehen sind, besteht des Problem, dass diese Schicht aus einem Oxid des Chroms oder einer chromhaltigen Legierung nicht mit der geforderten Qualität an der betreffenden Folie haftet, also keine zufriedenstellende Haftfestigkeit aufweist. Ursache dafür ist die Verunreinigungsschicht, die bei dem nach der Herstellung der Folie erforderlichen Waschund Trockenprozess entsteht Auch durch eine Reihe von Versuchen zur Änderung des Wasch- und Trockenprozesses und die Verwendung von Netzmrtteln, durch Spülen in basischem oder saurem Medium, durch Versuche zum Abätzen einer aberflächlichen Oxidschicht sowie durch Versuche einer gezielten Oxidation konnte die Verunreinigungsschicht nicht beseitigt werden. Auch eine Säure-Behandlung unmittelbar vor dem Vakuumbeschichtungsprozess wurde getestet Es musste festgestellt werden, dass das bisher vorgeschlagene Verfahren das Optimum im Rahmen des vorgeschlagenen Verfahrens darstellt und durch keine der vorstehend erwähnten Bemühungen verbessert werden konnte. Auch das Optimieren des Ptasma-Vorbehandlungsprozesses in wiederholten Versuchsreihen hat zu keinen restlos befriedigenden Ergebnissen geführt

Der Erfindung liegt die Aufgabe zugrunde, das Verfahren zum Beschichten von Folie aus Nickel oder einer Nickellegierung und eine beschichtete Folie aus Nickel oder einer Nickellegierung, vorzugsweise eine Scherfolie für Elektro-Rasierapparate. die eine in beliebiger Farbe herstellbare, fest haftende, verschleißarme Schicht mit einer sehr geringen Dicke besitzt, nach der Patentanmeldung 198 00 758.2 derart auszugestalten, dass die nach dem Wasch- und Trockenprozess entstehende Verunreinigungsschicht, die auch durch den nachfolgenden Plasmabehandlungsprozess nicht restlos zu beseitigen ist, keine negativen Auswirkungen auf die Gebrauchsdauer bei der abrasiven Belastung der Folie hervorruft. Es soll ebenso wie nach dem bereits vorgeschlagenen Verfahren die spezielle Forderung, dass die Farbtoleranzen sehr gering und die Farbgleichmäßigkeit sehr hoch sein sollen, erfüllt werden. Das Verfahren soll hochproduktiv und wirtschaftlich, d.h. automatisierbar sein. Auch die Forderung, dass das Beschichten ohne thermische Überlastung der Folien erfolgt, muss erfüllt werden. Die vorgeschlagene Folie soll mit einem Indikator für die Gebrauchsdauer bei abrasiver Belastung, insbesondere beim Einsatz für Elektro-Rasierapparate, versehen werden können und sich durch eine Einstellbarkeit dieses Indikators auf einen vorgegebenen Wertebereich auszeichnen. Diese Gebrauchseigenschaften sollen nicht negativ durch den Wasch- und Trockenprozess vor der Beschichtung beeinflusst werden.

Es wurde gefunden, dass das bisher vorgeschlagene Verfahren dadurch verbessert werden kann, wenn vor dem reaktiven Aufstäuben der Schicht aus Chromoxid oder dem Oxid einer chromhaltigen Legierung eine Schicht aus Chrom oder einer Chromlegierung auf die partiell verschmutzte Nickel-Oberfläche der Folie aufgebracht wird, nachdem die Folie aus Nickel oder einer Nickellegierung einer Plasmabehandlung unterzogen wurde. Man kann das erfindungsgemäße Verfahren als "Prinzip der begrabenen Nickel-Oberfläche" bezeichnen. Auf die partiell verschmutzte Nickel-oberfläche wird nach einem Plasma-Vorbehandlungsprozess zunächst eine Schicht aus Chrom oder einer Chromlegierung mit einer Dicke von einigen Nanometern aufgebracht. Dabei werden durch die partielle Aufoxidation des Chroms die sich an der Atmosphäre bildenden Nickeloxide und Fremdschichten reduziert und von der Schicht aus Chrom oder der Chromlegierung bedeckt. Der dem Aufstäuben der Chromschicht vorangehende zwingend erforderliche Plasmaprozess gewährleistet eine gute Haftung zwischen der partiell verschmutzten Nickel-Oberfläche und der Chromschicht bzw. der Chromlegierungsschicht. Die Schicht aus Chrom bzw. der Chromlegierung muss so dick sein, dass sie oberflächlich metallisch und hochreflektierend ist. Darauffolgend kann die als interferenzschicht wirkende Chromoxidschicht auf die aufgestäubte Schicht aus Chrom bzw. der Chromlegierung in bekannter Weise aufgebracht werden. Da die Beschichtung ohne Vakuum-Unterbrechung erfolgt, wird zwischen der Schicht aus Chrom bzw. der Chromlegierung in statu nascendi und der Chromoxidschicht ohne erneutes Plasma-Ätzen eine sehr gute Haftung erreicht. Dieses "Prinzip der begrabenen Nickel-Oberfläche" bildet zunächst mit Mitteln der PVD eine gut haftende Oberfläche des Chroms bzw. der Chromlegierung, bevor das Aufstäuben der optisch wirksamen Interferenzschicht aus Chromoxid oder eines Oxids einer chromhaltigen Legierung erfolgt Sie nutzt weiterhin das gute Haftvermögen von Chrom und Chromlegierungen auf Nickel und das ebenfalls gute Haftvermögen von Chromoxid auf Chrom aus.

Die erfindungsgemäß beschichtete Folie aus Nickel oder einer Nickellegierung - auf welche ein Schichtsystem aufgebracht ist, das aus einer auf der Folie aufgestäubten Schicht aus Chrom oder einer Chromlegierung besteht, auf die eine Schicht aus Chromoxid oder dem Oxid einer chromhaltigen Legierung aufgestäubt ist - gewährleistet, dass die durch den Wasch- und Trockenprozess der Folie nach deren Herstellung entstehende Verunreinigungsschicht keinen negativen Einfluss auf die Eigenschaften der beschichteten Folie hat.

Es ist vorteilhaft, wenn die aufgestäubte Schicht aus Chrom oder einer Chromlegierung eine Dicke von 3 nm bis 20 nm hat

An einem Ausführungsbeispiel wird die Erfindung nachfolgend näher beschrieben.

Nach der Erfindung werden Scherfolien für Elektro-Rasierapparate hergestellt.
Eine solche galvanisch hergestellte Folie aus Nickel hat eine Dicke von 50 µm und besitzt ein Muster von Durchbrüchen für die Barthaare. Die Folien sollen typenabhängig markiert, ästhetisch-gestalterisch aufgewertet und in Bezug auf ihre mittlere Gebrauchsdauer markiert werden.

Das Verfahren wird in einer bekannten Mehrkammer-Zerstäubungsanlage mit linearem Durchlauf der zu beschichtenden Folien ausgeführt. Die Folien werden dazu auf Trägerplatten aus 10 mm dicken Alu-Tafeln gelegt, die mit einer hartmagnetischen Polymerfolie beklebt sind. Die Plasmabehandlung und das Beschichten erfolgen in Verbünden aus einzelnen Folien, die je eine Fläche von 80 cm x 50 cm bilden. Die magnetische Anziehungskraft der Polymerfolie sichert einen definierten und intensiven Wärmekontakt zwischen den Folien und den als Wärmepuffer wirkenden Trägerplatten. Nach dem Einschleusen der Trägerplatten mit den darauf haftenden Folien in das Vakuum wird in einer folgenden Vakuumkammer mittels eines Gaseinlasses ein Argondruck von 3·10⁻³ mbar eingestellt Mittels einer lonenquelle erfolgt in bekannter Weise die Plasmabehandlung. Die Trägerplatte mit darauf haftenden Folien pendelt mehrmals durch den Strom von Ionen, der durch die lonenquelle erzeugt wird.

In einer weiteren anschließenden Vakuumkammer ist eine Magnetron-Zerstäubungsquelle mit einem Chmmtarget angeordnet. Über ein Gaseinlasssystem wird Argon als Prozessgas zugeführt. In dieser Vakuumkammer wird die erfindungsgemäße Chromschicht aufgebracht, die die Verunreinigungen bedeckt und unwirksam macht

In der nächsten Vakuumkammer erfolgt das Beschichten durch reaktives Magnetron-Zerstäuben zweier Chrom-Platten, die jeweils Target einer Magnetron-Zerstäubungsquelle sind. Dazu wird mittels eines Gaseinlasssystems sowohl Argon als auch Sauerstoff eingelassen. Ein Sinusgenerator speist eine Leistung von 10 kW in die gemeinsam arbeitenden Magnetron-Zerstäubungsquellen derart ein, dass die Targets mit einer Frequenz von 50 kHz abwechselnd als Kathode und Anode einer Magnetron-Gasentladung geschaltet werden. Durch dieses Dual-Magnetron-System erfolgt das Puls-Zerstäuben, welches einen langzeitstabilen Beschichtungsprozess in dem Argon Sauerstoff-Gemisch bei einem Druck von etwa 2·10⁻³ mbar sichert. Der Sauerstoffanteil wird dabei so geregelt, dass die Intensität einer charakteristischen Emissionslinie des Plasmas genau 10 % der Intensität beim Zerstäuben ohne Sauetstoff, d.h. im reinen Argon, beträgt.
Während des ersten metallischen und des zweiten reaktiven Beschichtens mit Chrom wird die Trägerplatte mit den Folien periodisch mit einer festen Geschwindigkeit linear durch den Strom der kondensierenden Teilchen bewegt.

Die gebildeten stöchiometrischen Chrom-Oxidschichten auf der Chromschicht mit einer Schichtdicke in dem genannten Schichtdickenbereich auf den Folien zeichnen sich durch hohe Abrasionsbeständigkeit und hohe Farbbrillanz aus. Nach diesem Zerstäubungsprozess erfolgt in bekannter Weise das Ausschleusen der Folien mit den erfindungsgemäß aufgestäubten Schichten an Luft.

## Patentansprüche

1. Verfahren zum Beschichten von Folie aus Nickel oder einer Nickellegierung, die vorzugsweise galvanisch hergestellt ist, durch Aufstäuben einer Schicht aus einer Metallverbindung in einem Vakuum auf die Folie im Bereich von mindestens einer Seite der Folie, indem die Folie in einem Argonplasma bei einem Druck von 10⁻³ bis 10⁻² mbar eine einstellbare Zeit mit einer einstellbaren Rate und Energie der ionen des Plasmas behandelt wird, und anschließend durch reaktives Magnetron-Zerstäuben mindestens eines Targets aus Chrom oder einer chromhaltigen Legierung mit mindestens einer Zerstäubungsquelle in einem Argon-Sauerstoff-Gemisch bei einem Druck von 10⁻³ bis 10⁻² mbar eine Chromoxidschicht oder eine chromoxidhaltige Schicht aufgestäubt wird, wobei der Arbeitspunkt in vorgegebenen Grenzen konstant gehalten wird und während des Beschichtens die Folie in einem definierten Wärmekontakt mit einem Wärmepuffer verbunden wird und bis zum Erreichen einer vorgegebenen Interferenzfarbe einer Interferenz erster oder zweiter Ordnung auf der Folie beschichtet wird,
wobei nach der Plasmabehandlung der Folie eine Schicht aus Chrom oder einer Chromlegierung durch Magnetron-Zerstäuben in Argon bei einem Druck von 10⁻³ bis 10⁻² mbar auf die plasmabehandelte Folie aufgestäubt wird.

2. Verfahren nach Anspruch 1, **dadurch gekennzeichnet, dass** die Schicht aus Chrom oder einer Chromlegierung in einer Dicke von 3 nm bis 20 nm aufgestäubt wird.

3. Beschichtete Folie aus Nickel oder einer Nickellegierung, die vorzugsweise nach einem galvanischen Verfahren hergestellt ist und auf die im Bereich von mindestens einer Seite eine in einem Vakuum aufgestäubte Schicht aus einer Metallverbindung aufgebracht ist, die Schicht aus einem Oxid des Chroms oder einer chromhaltigen Legierung besteht, die Dicke dieser Schicht durch eine vorgegebene Interferenzfarbe einer Interferenz erster oder zweiter Ordnung bestimmt ist und in einem Schichtdickenbereich zwischen 20 und 300 nm liegt, wobei
zwischen der Folie und der aufgestäubten Schicht aus einem Oxid des Chroms oder einer chromhaltigen Legierung eine Schicht aus Chrom oder einer Chromlegierung aufgebracht ist

4. Beschichtete Folie aus Nickel oder einer Nickellegierung nach Anspruch 3, **dadurch gekennzeichnet, dass** die Schicht aus Chrom oder der Chromlegierung 3 nm bis 20 nm dick ist.

## Claims

1. Process for coating foil comprised of nickel or a nickel alloy, which is preferably produced by electrodeposition, by sputtering a film of a metal compound onto the foil in vacuo in the area of at least one side of the foil, by treating the foil in an argon plasma at a pressure of 10⁻³ to 10⁻² mbar, for an adjustable time and with an adjustable rate and energy of the ions of the plasma, and then sputtering a chromium oxide film or a chromium-oxide-containing film by reactive magnetron sputtering of at least one target made from chromium or a chromium-containing alloy using at least one sputtering source in an argon-oxygen mixture at a pressure of 10⁻³ to 10⁻² mbar, the operating point being kept constant within defined limits, and connecting the foil in defined thermal contact to a heat buffer during the coating of the foil, and continuing the coating of the foil until a predetermined interference colour with an interference of the first or second order is reached,
in which process, after the plasma treatment of the foil, a film of chromium or a chromium alloy is sputtered onto the plasma-treated foil by magnetron sputtering under argon at a pressure of 10⁻³ to 10⁻² mbar.

2. Process according to claim 1, **characterized in that** the film of chromium or a chromium alloy is sputtered in a thickness of from 3 nm to 20 nm.

3. Coated foil comprised of nickel or a nickel alloy which is preferably produced using an electrodeposition process and to which a film of a metal compound which is sputtered on in vacuo has been applied in the area of at least one side, the film consists of an oxide of chromium or a chromium-containing alloy, the thickness of this film is determined by a specified interference colour with an interference of the first or second order and is in a film-thickness range of between 20 and 300 nm, and a film of chromium or a chromium alloy is applied between the foil and the sputtered film of an oxide of chromium or a chromium alloy.

4. Coated foil comprised of nickel or a nickel alloy according to claim 3, **characterized in that** the film of chromium or the chromium alloy is from 3 nm to 20 nm thick.

## Revendications

1. Procédé d'application d'un revêtement sur une feuille en nickel ou en un alliage de nickel, qui de préférence est fabriquée par voie électrolytique, par pulvérisation ou vaporisation sur la feuille, sous vide, d'une couche d'un composé de métal, sur une zone de la feuille correspondant à au moins une face de celle-ci, selon lequel la feuille est traitée dans un plasma d'argon, à une pression de 10⁻³ à 10⁻² mbar, pendant un temps réglable, avec un taux et une énergie réglables des ions du plasma, et selon lequel ensuite, par vaporisation réactive par magnétron d'au moins une cible en chrome ou alliage à teneur en chrome avec une source de vaporisation dans un mélange d'argon et d'oxygène, à une pression de 10⁻³ à 10⁻² mbar, on dépose par vaporisation une couche d'oxyde de chrome ou une couche à teneur en oxyde de chrome, le point de fonctionnement étant maintenu constant dans des limites prescrites, et la feuille étant reliée durant l'application du revêtement, par un contact calorifique défini, à un tampon calorifique, l'application du revêtement sur la feuille se poursuivant jusqu'à atteindre une teinte d'interférence prescrite d'une interférence de premier ou de second ordre,
le procédé prévoyant après le traitement au plasma de la feuille, l'application par vaporisation sur la feuille traitée au plasma, d'une couche de chrome ou d'un alliage de chrome selon un processus de vaporisation par magnétron dans l'argon, à une pression de 10⁻³ à 10⁻² mbar.

2. Procédé selon la revendication 1, **caractérisé en ce que** la couche de chrome ou d'un alliage de chrome est appliquée par vaporisation sur une épaisseur de 3 nm à 20 nm.

3. Feuille de nickel ou d'alliage de nickel, revêtue, qui de préférence est fabriquée par voie électrolytique, et sur laquelle est appliquée, dans une zone correspondant à au moins une face, une couche d'un composé de métal déposée par vaporisation sous vide, la couche étant formée par un oxyde de chrome ou d'un alliage à teneur en chrome, l'épaisseur de cette couche étant déterminée par une teinte d'interférence prescrite d'une interférence de premier ou de second ordre et se situant dans une plage d'épaisseur de couche comprise entre 20 et 300 nm,
et une couche de chrome ou d'un alliage de chrome étant appliquée entre la feuille et la couche constituée par un oxyde de chrome ou d'un alliage à teneur en chrome appliquée par vaporisation.

4. Feuille de nickel ou d'alliage de nickel, revêtue, selon la revendication 3, **caracterérisé en ce que** la couche de chrome ou d'un alliage de chrome a une épaisseur de 3 nm à 20 nm.
